# EUROPEAN PATENT SPECIFICATION

(11) **EP 0 457 501 B1**
(45) Date of publication and mention of the grant of the patent: **09.08.1995**
(21) Application number: 91304187.7
(22) Date of filing: 09.05.1991
(51) Int. Cl.: H05K 3/46, H05K 3/06

(54) **Method of manufacturing a multilayer wiring board**
Verfahren zur Herstellung einer Mehrschichtleiterplatte
Procédé pour fabriquer une plaquette de câblage à plusieurs couches

(30) Priority: 18.05.1990 JP 127051/90
(43) Date of publication of application: 21.11.1991
(73) Proprietor: International Business Machines Corporation, Armonk, N.Y. 10504 (US)
(72) Inventor: Okabe, Shuichi, Yasu-gun, Shiga-ken (JP)
(74) Representative: Burt, Roger James, Dr.

(56) References cited:
- EP-A- 0 246 447
- DE-A- 3 221 826
- DE-A- 3 524 807
- US-A- 3 554 876
- US-A- 4 659 587

## Description

This invention relates to a method of manufacturing a multilayer wiring board and especially to a method for forming interlayer connection in multilayer wiring boards. This method is useful in many areas of wiring board manufacture and is particularly useful for manufacturing multilayer printed circuit boards for use in computers that require high-density packaging.

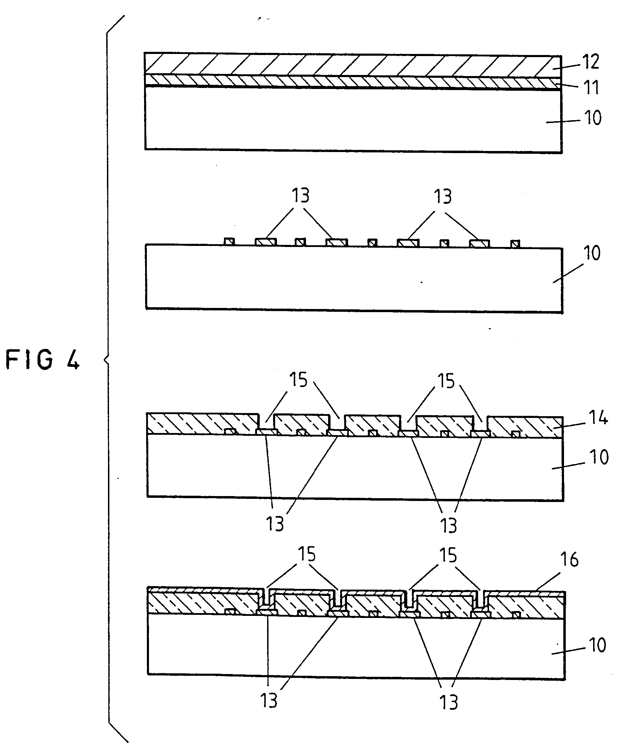

Prior art techniques for forming interlayer connections for thin-film multilayer wiring on an organic substrate consisting of materials such as ceramic include the insulation-layer etching method and the plating pillar method. Figure 4 shows the steps involved in the insulation-layer etching method. In this method a conductor 11 is formed on a substrate 10 having an insulation layer. Then, photoresist 12 is blanket-applied onto the conductor 11, which is selectively exposed and developed. Next the conductor 11 is selectively etched to form lower-layer wiring 13 on desired locations, and remaining photoresist is removed. An insulation layer 14 consisting of photosensitive resin is then deposited on the formed lower-layer wiring 13 and vias 15 are formed by a dry or wet etching method to selectively expose the lower-layer wiring 13. Then, upper-layer wiring 16 is deposited on the vias 15 and the exposed lower-layer wiring 13 using a film forming technique such as electroless plating, deposition, and sputtering. Multilayer wiring is formed on the organic substrate through repeated formation of the insulation and the wiring layers.

JP-A-51-118390 describes a predetermined multilayer wiring structure that is formed by forming a polyimide resin film on a printed circuit board on which Al wiring conductors are formed, and then forming an organic Al-compound layer on the surface of the polyimide resin film. Next parts of the organic Al-compound layer are selectively removed from the polyimide resin film so as to form through-holes therein, and a second conductor layer of Al is formed in the through-holes.

JP-A-58-93298 describes a lower-layer wiring pattern that is produced by forming a wiring conductor layer on a substrate, and then forming a resist layer thereon. Next the resist layer is partly removed to form through-holes and an interlayer insulation film constituting multilayer wiring is formed by using a polyimide-based resin. A resist film is then formed on the insulation layer, connecting through-holes are formed by partly removing the resist film, the insulation layer is baked and upper-layer wiring is formed on the resulting insulation layer. JP-A-60-180197 describes multilayer wiring patterns that are produced by forming a primary layer wiring pattern on an insulation substrate, forming a photopolymer film on the primary layer, and exposing, photo-setting and developing the photopolymer film to form a photo-set film with via holes at predetermined positions. Then, secondary layer wiring patterns are formed on the photo-set film of the photopolymer and on the via hole portions, and said photopolymer-film forming processes and wiring pattern forming processes are repeated in turn thereafter.

In JP-A-61-121393 and JP-A-61-127196, a method is described which uses the above insulation layer etching method to form wiring patterns of materials such as copper or chromium on an insulation layer surface through plating, sputtering, or evaporation, and, at the same time, makes the via hole portions conductive in order to electrically connect with a lower-layer conductor pattern.

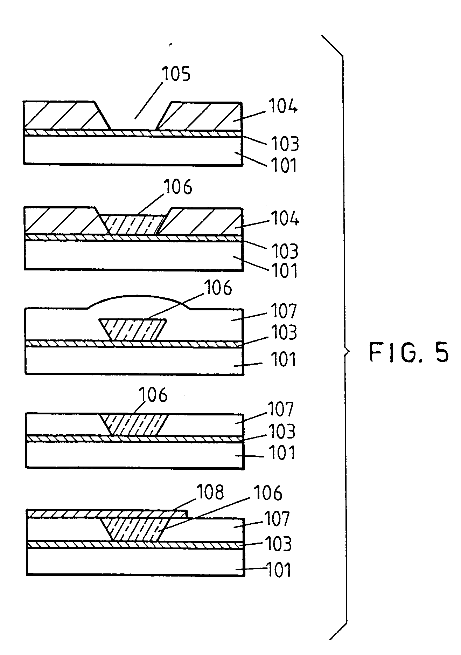

Figure 5 shows the steps involved in the plating pillar method. In this method, lower-layer wiring 103 is deposited on a substrate 101 blanket-coated with polyimide resin using film forming techniques such as sputtering. A bonding layer such as chromium is placed between the lower-layer wiring 103 and the substrate 101. Then photosensitive resist 104 is blanket-coated on the lower-layer 103, and selectively removed after pattern exposure and development to form a resist hole 105. A plating pillar 106 is formed in the resist hole 105 by, for example, electroplating, and then the resist 104 is removed by, for example, solvent. The lower-layer and plating pillar are then coated with polyimide 107 whose surface is smoothed by polishing to expose the head of the plating pillar 106, so as to enable upper-layer wiring 108 to be formed on it using a film forming technique such as sputtering. Multilayer wiring is formed by repeating the above processes.

JP-A-No.61-90496 describes a process in which a plating pillar is formed in a through-hole by firstly depositing a metal foil for conductor circuits on an insulation substrate and forming lower-layer wiring by photoresist application, pattern exposure, development, plating, resist removal, and etching. Then a polyimide film is formed on the lower-layer wiring and a through-hole is formed with a mechanical drill or laser beam at the portion to be made conductive. Next the plating pillar is formed by locally supplying plating solution and a laser beam.

JP-A-63-43396 describes a process in which multilayer wiring is produced by forming a lower layer of wiring on the entire surface of a multilayer wiring alumina substrate, and press-fitting a positive-type dry film before obtaining resist patterns by exposure and development. Next a plating pillar is produced in the formed via holes by electroplating, and the plated resist pattern is removed with solvent. The surface of the insulation layer is polished to expose the head of the plating column and then coated with an insulation layer. Via holes with a required diameter are formed in the insulation layer, copper is sputtered inside the via holes and on the surface of the insulation layer, and necessary circuit patterns are formed by etching.

JP-A-63-244797 describes a process in which necessary wiring is formed by laminating a positive-type dry film onto an alumina substrate (with lower-layer wiring patterns formed thereon) to make resist patterns. Resist holes are formed by exposure and development and then the resist holes are plated with copper sulphate to form a plating pillar, before removing the remaining resist with acetone. The pillar is then coated with a polyimide insulation layer, the surface of the insulation layer is polished to expose the head of the plating pillar, and a copper layer is formed on the surface of the insulation layer and the head of the plating pillar.

JP-A-61-179598 describes a process in which wiring is produced by forming photoresist patterns on,the surface of copper wiring patterns (formed on a ceramic substrate as lower-layer wiring) by an ordinary photolithography technique, and depositing a plating pillar by electroplating on the surface of the lower wiring layer exposed through photoresist holes. Then a polyimide resin is applied to the entire exposed surface of the plating pillar and substrate, and a predetermined pressure is applied to the lower-layer surface in the direction of the substrate in order to make the surface flat. Next an upper wiring layer is deposited at predetermined positions on the surface of the insulation layer.

JP-A-62-263645 describes a process in which predetermined patterns are formed on a substrate by etching chromium and copper layers that have been blanket-applied in turn on a substrate. Then a positive photoresist is blanket-applied onto the copper layer and the resist is exposed and developed to form an opening (via hole). The positive photoresist is silicated, a plating pillar is formed in the opening by dipping the opening in a molten-solder bath, the silicated resist remaining as a solder barrier, and upper-layer wiring is connected to the pillar.

JP-A-50-2059 describes a process in which an insulation substrate made of, for example, ceramic is covered with a copper layer as lower-layer wiring, photoresist is then deposited on the copper layer, and the photoresist is exposed and developed to form a resist hole. A conductive material (plating pillar) such as copper is deposited in the hole by electroplating, the residual photoresist is then removed and an insulating material such as epoxy resin is deposited. Next a copper layer is electroless-plated on the conductive and insulating materials to effect interlayer connection.

According to the above-mentioned insulation layer etching methods, the via diameter is limited to the minimum value that allows plating to take place, since the via formed by etching is required to be made conductive through plating. In addition, to electrically connect lower-layer wiring with upper-layer wiring, it is necessary to provide a land on the electric circuit at the bottom of the via. Since the land must be accurately aligned with the via, the electric-circuit forming density cannot be increased because the via diameter would have to be decreased accordingly (beyond its minimum value).

Furthermore, when a via is formed in an insulation layer by wet etching, the taper angle of the hole wall increases and refining becomes difficult because the insulation layer is etched while old etching solution is being replaced with new solution. Moreover, disconnection may occur between the lower-layer wiring and the upper-layer wiring if the resist is not completely removed from the lower-layer wiring. Therefore, perfect etching cannot always be expected. When the inside of the via is coated, the device reliability is degraded unless a uniform plating layer is formed on the side wall and the bottom.

On the other hand, when a via is formed in an insulation layer by dry etching, an organic substrate is not desirable because gas is produced, and a ceramic, silicone, or glass substrate is impracticable because etching takes a longer time unless the metal layer thickness is thin.

The above-mentioned plating pillar method has the disadvantage that extra processes are needed because photoresist is applied to or removed from an insulation layer solely to form a via bump (plating pillar).

An object of the invention is to attain interlayer connection of multilayer boards while increasing the electric-circuit forming density by greatly reducing the via diameter.

Another object of the invention is to decrease the number of manufacturing processes by using the same positive photoresist used to form the lower-layer electric circuit to also form the via bump, hence omitting the need for an extra photoresist applying process which is used in the prior art to form the via bump.

Still another object of the invention is to eliminate the land from the electric circuit on the bottom of the via.

In this invention, at least two different types of metal layers are formed on a substrate through lamination or plating, onto which photoresist is applied. The photoresist is then exposed, developed, and removed to form patterns, and a lower-layer electric circuit is formed on the substrate by etching along the patterns a number of times equal to the number of metal layers. Then the residual photoresist, except for the photoresist on the metal layers to be left as a via bump, is exposed, developed, and removed. Next the metal layers to be left as the electric circuit are etched along the formed resist patterns so that the metal layers to become the via bump remain. In this way a via bump is formed on the electric circuit which consists of metal layers that have not been etched. Since this invention, unlike the existing insulation layer etching method and the plating pillar method, uses a forming method in which the metal to become a via bump is etched to the desired size, the via diameter can be reduced until the metal to become the via bump almost disappears throngh etching. Moreover, since the metal layer to become the via bump is laminated on the metal layer to become an electric circuit, it is not necessary to provide a land on the electric circuit at the bottom of the via as in the insulation layer etching method. The present invention also allows the positive resist that remained after forming the lower-layer electric circuit to be used for forming the via bump, hence reducing the number of steps required.

The present invention will be described further, by way of example only, with reference to an embodiment thereof as illustrated in the accompanying drawings, in which:

Figure 1 (a) through (j) shows the steps necessary to produce a multilayer wiring board according to the preferred embodiment of the present invention.

Figure 2 (a) through (j) are plan views corresponding to Figure 1 (a) through (j) respectively.

Figure 3 shows a via bump as formed in another preferred embodiment.

Figure 4 shows the steps involved in the conventional insulation-layer etching method.

Figure 5 shows the steps involved in the conventional plating pillar method.

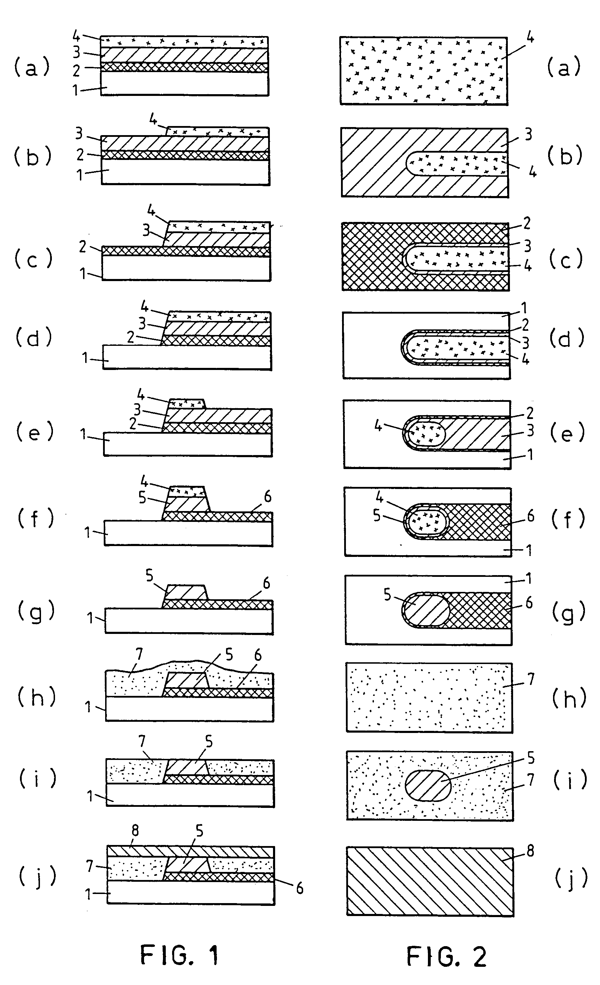

As shown in Figure 1 (a), a 10»m chromium blanket metal layer 2 and a 30»m copper blanket metal layer 3 are deposited on an organic substrate 1 by using known film forming techniques such as the evaporation, sputtering, and electroless-plating methods. Then, positive resist 4 is applied on the chromium layer 2 and the copper layer 3. Any of the easily-available photoresists such as AZ1350J (SHIPURE), TNS (IBM), and PMER-P (TOKYOOHKA) can be used. Application is usually made with a brush, a spin coating method, or by dipping.

Then, the positive photoresist 4 is exposed and developed through a mask (not shown), the wiring pattern portion of the mask being opaque and portions other than the wiring pattern portion being transparent. As shown in Figure 1 (b) and Figure 2 (b), areas other than the resist area corresponding to the area where the lower-layer wiring portion is formed are removed and the copper layer 3 is partially exposed.

As shown in Figure 1 (c) and Figure 2 (c), the copper layer 3 is etched with any suitable etching solution. This is wet etching in which an object is dipped, for example, in 50°C cupric chloride for about 150 sec. Then, the chromium layer 2 which is exposed by etching of the copper layer 3 is etched with any suitable chromium etching agent. This is wet etching in which an object is dipped, for example, in a 20°C mixed solution of three parts of concentrated hydrochloric acid and seven parts of water for 5 min. As a result, the surface of the substrate 1 is locally exposed as shown in Figure 1 (d) and Figure 2 (d).

For a substrate consisting of ceramic, silicone, or glass, a dry etching process may be applied, using a conventional gas such as Ar or CF4 suitable for the material to be etched, instead of the wet etching process discussed above.

The positive photoresist remaining after the above process is exposed through a mask (not shown), the via bump portion of the mask being opaque and portions other than the via bump portion being transparent, and is developed by a solution containing an oxidizing agent such as alkaline solution, nitric acid, sulphuric acid, and aqueous hydrogen peroxide. Thus, as shown in Figure 1 (e) and Figure 2 (e), areas other than the resist corresponding to the area where the via bump is to be formed are removed and the surface of the copper layer 3 is partially exposed. Then, as shown in Figure 1 (f) and Figure 2 (f), the copper layer 3 is etched by using a suitable etching agent. This is wet etching in which an object is dipped, for example, in etching solution consisting of cupric chloride. When the copper layer 3 is thus etched, the surface of the chromium layer 2 is partially exposed and, at the same time, the via bump 5 is formed under the residual resist.

Then the residual resist is removed to complete the formation of the via bump 5 and the lower-layer electric circuit 6, as shown in Figure 1 (g) and Figure 2 (g). The bump diameter (via diameter) can be reduced to about 0.015 mm by this invention, while the conventional via diameter can only be reduced to about 0.1 mm. Figure 1 (h) and Figure 2 (h) show a step in which organic insulating resin, such as epoxy resin, polyimide resin or acrylic resin, is blanket-applied, dried and set on the organic substrate 1, the via bump 5, and the lower-layer electric circuit 6 to cover their surfaces. Then, the surface of the organic insulating resin 7 is polished by a belt sander (a rotary polishing machine with sandpaper in the form of a belt) or a brush polishing machine (a polishing machine with an abrasive brush) to expose the head of the via bump 5 as shown in Figure 1 (i) and Figure 2 (i). Then, the upper-layer electric circuit metal layer 8 consisting of copper, etc. is formed on the surface of the organic insulating resin 7 and the via bump 5 by a film forming method such as electroplating. For a thin metal layer formed on a substrate such as ceramic, silicone, or glass, the film can be produced by a film forming technique such as sputtering or evaporation. Thus, the lower-layer electric circuit 6 is electrically connected with the upper-layer electric circuit through the via bump 5. Multilayer wiring can be formed by repeating the above process as required.

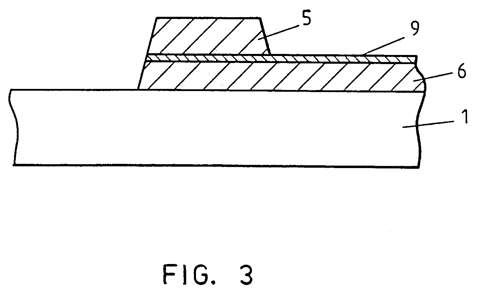

Figure 3 shows another preferred embodiment in a state where a via bump has been formed. The lower-layer electric circuit 6 is connected with the upper-layer electric circuit 8 (not shown) through the via bump 5 by depositing the upper-layer electric circuit 8 on the formed via bump 5.

In this embodiment, said organic substrate 1 is blanketed with a metal layer made of copper to become the lower-layer electric circuit 2, on which a tin layer 9 is blanket-coated to form a double-layer structure. The structure is further blanket-coated with a copper layer to become the via bump 5. The tin layer 9 serves as a mask so that the lower-layer electric circuit metal layer 6 will not be etched when the via bump 5 is formed. In this embodiment the type of the metal layer to be formed on the substrate and the number of metal layers used are different to those in the previous embodiment. However, the series of processes to form the via bump 5 is the same. Cupric chloride is used as the etching solution for the lower metal layer made of copper and for the copper layer 5 used to produce the via bump 5, and a mixed solution of ammonium fluoride and aqueous hydrogen peroxide is used as the etching solution for the tin layer 9.

The preferred embodiment hereinbefore described makes it possible to increase the electric-circuit forming density in interlayer connections of multilayer boards by greatly reducing the minimum via diameter achievable with prior art techniques. It also permits the omission of the extra resist applying process required in the prior art to form the via bump, since the same positive photoresist used to form the lower-layer electric circuit can be used to form the via bump. Thus, the number of manufacturing processes can be reduced.

## Claims

1. A method of manufacturing a multilayer wiring board comprising interlayer connection between a first electric circuit pattern and a second electric circuit pattern, both electric circuit patterns being formed on a substrate (1), said method characterised by the steps of:
applying a first metal layer (2) onto said substrate (1) and a second metal layer (3) onto said first metal layer (2);
selectively etching said second metal layer (3) to partially expose regions of said first metal layer (2) not required to form said first electric circuit pattern;
etching the exposed regions of said first metal layer (2) to expose corresponding regions of said substrate (1) and to form said first electric circuit pattern;
etching said second metal layer so that the remaining second metal layer forms a via bump (5), said via bump (5) being located in a position where said interlayer connection is required;
applying an insulation layer (7) to cover said first electric circuit pattern while leaving one end of said via bump (5) exposed; and
applying a third metal layer (8) onto said insulation layer (7) and the exposed end of said via bump (5), and etching said third metal layer (8) to form said second electric circuit pattern, said via bump (5) thereby providing interlayer connection between said first and second electric circuit patterns.

2. A method as claimed in Claim 1 comprising the steps of:
sequentially blanket coating said first (2) and second (3) metal layers onto said substrate;
blanket coating a positive photoresist (4) onto the second metal layer (3);
exposing and developing said photoresist (4) to remove some regions of said photoresist thus defining a first predetermined pattern;
etching said second metal layer not coated with said photoresist (4) to partially expose said first metal layer (2), and further etching the exposed first metal layer to form said first electric circuit pattern;
exposing and developing the residual photoresist remaining after the exposure and development step to define a second predetermined pattern;
etching the second metal layer (3) in accordance with said second predetermined pattern to form said via bump (5);
removing all remaining photoresist from said second metal layer (3);
blanket coating an organic insulation layer (7) to cover the etched first and second metal layers;
flattening the surface of said organic insulation layer (7) to expose the surface of said via bump (5); and
depositing said third metal layer (8) constituting said second electric circuit pattern on said organic insulation layer (7) and the exposed surfaces of said via bump (5).

3. A method as claimed in Claim 1 or Claim 2 wherein said second metal layer (3) is a copper layer, and etching of said copper layer is performed by wet etching using cupric chloride.

4. A method as claimed in Claim 1 or Claim 2, wherein said second metal layer (3) is a chromium layer, and etching of said chromium layer is performed by wet etching using a mixed solution of concentrated hydrochloric acid and water.

5. A method as claimed in any preceding claim, wherein the said first metal layer (2) is a copper layer, and etching of said copper layer is performed by wet etching using cupric chloride.

6. A method as claimed in any preceding claim, wherein a passivation layer is deposited between said first (2) and second (3) metal layers to prevent said first metal layer (2) being etched during etching of said second metal layer (3).

7. A method as claimed in Claim 6, wherein said passivation layer consists of tin, and etching of said passivation layer is performed by wet etching using a mixed solution of ammonium fluoride and aqueous hydrogen peroxide.

## Patentansprüche

1. Eine Methode zur Herstellung einer Mehrschicht-Leiterplatte mit einer Zwischenschichtverbindung zwischen einem ersten elektrischen Schaltungsbild und einem zweiten elektrischen Schaltungsbild, wobei die beiden elektrischen Schaltungsbilder auf einem Substrat (1) gebildet werden, und die genannte Methode durch folgende Schritte gekennzeichnet ist:
Aufbringen einer ersten Metallschicht (2) auf dem genannten Substrat (1) und einer zweiten Metallschicht (3) auf der genannten ersten Metallschicht (2);
selektives Ätzen der genannten zweiten Metallschicht (3), um Bereiche der genannten ersten Metallschicht (2), die für die Bildung des genannten ersten elektrischen Schaltungsbildes nicht benötigt werden, teilweise freizulegen;
Ätzen der freigelegten Bereiche der genannten ersten Metallschicht (2), um die entsprechenden Bereiche des genannten Substrats (1) freizulegen und das genannte erste elektrische Schaltungsbild zu bilden;
Ätzen der genannten zweiten Metallschicht, so daß die verbleibende zweite Metallschicht einen Kontakthöcker (5) bildet, wobei der genannte Kontakthöcker (5) an der Stelle liegt, an der die genannte Zwischenschichtverbindung erfolgen soll;
Auftragen einer Isolierschicht (7), um das genannte erste elektrische Schaltungsbild abzudecken, wobei ein Ende des genannten Kontakthöckers (5) frei bleibt; und
Aufbringen einer dritten Metallschicht (8) auf die genannte Isolierschicht (7) und das freiliegende Ende des genannten Kontakthöckers (5), und Ätzen der genannten dritten Metallschicht (8), um das genannte zweite elektrische Schaltungsbild zu bilden, wodurch der genannte Kontakthöcker (5) eine Zwischenschichtverbindung zwischen den genannten ersten und zweiten elektrischen Schaltungsbildern herstellt.

2. Eine Methode nach Anspruch 1, folgende Schritte umfassend:
sequentielles Abdecken des genannten Substrats mit der genannten ersten (2) und zweiten (3) Metallschicht;
Abdecken der zweiten Metallschicht (3) mit einem positiven Photoresist (4);
Belichten und Entwickeln des genannten Photoresists (4), um einige Bereiche des genannten Photoresists abzutragen, wodurch ein erstes vorbestimmtes Muster festgelegt wird;
Ätzen der genannten zweiten Metallschicht, die mit dem genannten Photoresist (4) nicht abgedeckt wurde, um teilweise die genannte erste Metallschicht (2) freizulegen, und weiter Ätzen der freigelegten ersten Metallschicht, um das genannte erste elektrische Schaltungsbild zu bilden;
Belichten und Entwickeln des restlichen Photoresists, das nach dem Belichtungs- und Entwicklungsschritt übrig bleibt, um ein zweites vorbestimmtes Muster festzulegen;
Ätzen der zweiten Metallschicht (3) entsprechend dem genannten zweiten vorbestimmten Muster, um den genannten Kontakthöcker (5) zu bilden;
Abtragen des verbleibenden Photoresists von der genannten zweiten Metallschicht (3);
Deckendes Auftragen einer organischen Isolierschicht (7), um die geätzte erste und zweite Metallschicht abzudecken;
Abflachen der Oberfläche und der genannten organischen Isolierschicht (7), um die Oberfläche des genannten Kontakthöckers (5) freizulegen; und
Abscheiden der genannten dritten Metallschicht (8), die das genannte zweite elektrische Schaltungsbild bildet, auf der genannten organischen Isolierschicht (7) und den freigelegten Oberflächen des genannten Kontakthöckers (5).

3. Eine Methode nach Anspruch 1 oder 2, bei der die genannte zweite Metallschicht (3) eine Kupferschicht ist, und bei der das Ätzen der genannten Kupferschicht im Naßätzverfahren unter Verwendung von Kupfer-II-Chlorid durchgeführt wird.

4. Eine Methode nach Anspruch 1 oder 2, bei der die genannte zweite Metallschicht (3) eine Chromschicht ist, und das Ätzen der genannten Chromschicht im Naßätzverfahren unter Verwendung einer Mischlösung aus konzentrierter Chlorwasserstoffsäure und Wasser ausgeführt wird.

5. Eine Methode nach jedem vorangehenden Anspruch, bei der die genannte erste Metallschicht (2) eine Kupferschicht ist, und das Ätzen der genannten Kupferschicht im Naßätzverfahren unter Verwendung von Kupfer-II-Chlorid ausgeführt wird.

6. Eine Methode nach jedem vorangehenden Anspruch, bei der eine Passivierungsschicht zwischen der genannten ersten (2) und zweiten (3) Metallschicht abgeschieden wird, um zu verhindern, daß die genannte erste Metallschicht (2) beim Ätzen der genannten zweiten Metallschicht (3) geätzt wird.

7. Eine Methode nach Anspruch 6, bei der die genannte Passivierungsschicht aus Zinn besteht und das Ätzen der genannten Passivierungsschicht im Naßätzverfahren erfolgt, unter Verwendung einer Mischlösung aus Ammoniumfluorid und wäßrigem Wasserstoffperoxid.

## Revendications

1. Un procédé de fabrication d'une plaquette de câblage multicouche comprenant une connexion intercouche entre une première configuration de circuit électrique et une seconde configuration de circuit électrique, les deux configurations de circuit électrique étant formées sur un substrat (1), ledit procédé étant caractérisé par les étapes suivantes:
- l'application d'une première couche de métal (2) sur ledit substrat (1) et d'une deuxième couche de métal (3) sur ladite première couche de métal (2);
- l'attaque sélective de ladite deuxième couche de métal (3) afin d'exposer partiellement des régions de ladite première couche de métal (2) non requises pour la formation de ladite première configuration de circuit électrique;
- l'attaque des régions exposées de ladite première couche de métal (2) afin d'exposer des régions correspondantes dudit substrat (1) et de former ladite première configuration de circuit électrique;
- l'attaque de ladite deuxième couche de métal de façon que la deuxième couche de métal restante forme une protubérance de traversée (5), ladite protubérance de traversée (5) étant disposée à un emplacement où ladite connexion intercouche est requise;
- l'application d'une couche d'isolation (7) pour recouvrir ladite première configuration de circuit électrique tout en laissant une extrémité de ladite protubérance de traversée (5) exposée; et
- l'application d'une troisième couche de métal (8) sur ladite couche d'isolation (7) et sur l'extrémité exposée de ladite protubérance de traversée (5), et l'attaque de ladite troisième couche de métal (8) afin de former ladite seconde configuration de circuit électrique, ladite protubérance de traversée (5) assurant ainsi ladite connexion intercouche entre lesdites première et seconde configurations de circuit électrique.

2. Un procédé selon la revendication 1 comprenant les étapes suivantes:
- le revêtement par recouvrement séquentiel desdites première (2) et deuxième (3) couches de métal sur ledit substrat;
- le revêtement par recouvrement d'un matériau photorésistant positif (4) sur ladite deuxième couche de métal (3);
- l'exposition et le développement dudit matériau photorésistant (4) afin de retirer certaines régions dudit matériau photorésistant et de définir ainsi une première configuration prédéterminée;
- l'attaque de ladite deuxième couche de métal non revêtue dudit matériau photorésistant (4) afin d'exposer partiellement ladite première couche de métal (2), et encore l'attaque de la première couche de métal exposée afin de former ladite première configuration de circuit électrique;
- l'exposition et le développement du matériau photorésistant résiduel restant après l'étape d'exposition et de développement afin de définir une seconde configuration prédéterminée;
- l'attaque de la deuxième couche de métal (3) selon ladite seconde configuration prédéterminée afin de former ladite protubérance de traversée (5);
- le retrait de tout le matériau photorésistant de ladite deuxième couche de métal (3);
- le revêtement par recouvrement d'une couche d'isolation organique (7) afin de recouvrir les première et deuxième couches de métal attaquées;
- l'aplanissement de la surface de ladite couche d'isolation organique (7) afin d'exposer la surface de ladite protubérance de traversée (5); et
- le dépôt de ladite troisième couche de métal (8) constituant ladite seconde configuration de circuit électrique sur ladite couche d'isolation organique (7) et sur les surfaces exposées de ladite protubérance de traversée (5).

3. Un procédé selon la revendication 1 ou la revendication 2 dans lequel ladite deuxième couche de métal (3) est une couche de cuivre et dans lequel l'attaque de ladite couche de cuivre est exécutée par attaque humide en utilisant du chlorure cuivrique.

4. Un procédé selon la revendication 1 ou la revendication 2 dans lequel ladite deuxième couche de métal (3) est une couche de chrome, et dans lequel l'attaque de ladite couche de chrome est exécutée par attaque humide en utilisant une solution mixte d'acide chlorydrique et d'eau.

5. Un procédé selon l'une quelconque des revendications précédentes dans lequel ladite première couche de métal (2) est une couche de cuivre et dans lequel l'attaque de ladite couche de cuivre est exécutée par attaque humide en utilisant du chlorure cuivrique.

6. Un procédé selon l'une quelconque des revendications précédentes dans lequel une couche de passivation est déposée entre lesdites première (2) et deuxième (3) couches de métal pour empêcher l'attaque de ladite première couche de métal (2) pendant l'attaque de ladite deuxième couche de métal (3).

7. Un procédé selon la revendication 6 dans lequel ladite couche de passivation est en étain et dans lequel l'attaque de ladite couche de passivation est exécutée par attaque humide en utilisant une solution mixte de fluorure d'ammonium et de péroxyde d'hydrogène aqueux.
